# EUROPEAN PATENT APPLICATION

(11) **EP 1 983 578 A2**
(43) Date of publication of application: **22.10.2008**
(21) Application number: 08007292.9
(22) Date of filing: 14.04.2008
(51) Int. Cl.: H01L 31/048

(54) **Elongated eloctronid device, particularly for embedding in a photovoltaic module**

(30) Priority: 18.04.2007 ES 200700800 U
(71) Applicant: IFV-ENSOL, S.L., 28816 Camarma de Esteruelas Madrid (ES)
(72) Inventor: Bartolome Tabladillo, Daniel, 28816 Camarma De Esteruelas (Madrid) (ES); Fornies Garcia, Eduardo, 28816 Camarma De Esteruelas (Madrid) (ES); Llaneza Caruana, Benjamin, 28816 Camarma De Esteruelas (Madrid) (ES); Tojeiro Lorente, Marta, 28816 Camarma De Esteruelas (Madrid) (ES)
(74) Representative: Isern-Jara, Nuria

(57) **Abstract**

Elongated electronic device (4), with by-pass diodes, particularly for insertion on the inside of an easily repairable photovoltaic module, between the layers of encapsulating material, photovoltaic cells matrix (13), glass superstrate and rear insulating sheet, made from tin plated copper conductors (6) that have high conductivity and section, placed in a reliable and safe manner on an elongated plate of epoxy resin with glass fibre (5), onto which three Schottky type by-pass diodes (8) are assembled for the protection of the photovoltaic module, that are connected to the conducting cables for the electricity generated by the photovoltaic module, the front face of the module being covered with an opaque white primer (1) of a non-conductive material, without ionic contamination and resistant to ultra-violet radiation.

## Description

### OBJECT OF THE INVENTION

This present invention refers to a very long electronic device, embedded into a photovoltaic module between the layers of the encapsulating material, the glass superstrate, photovoltaic cell matrix and rear insulating sheet and is made up of a resin substrate with glass fibre onto which some high conductivity and section tin-plated copper panels have been deposited and, some Schottky type by-pass diodes have been assembled with special encapsulation for the electrical protection of said photovoltaic module from possible shade or bad electrical performance of some of the photovoltaic cells that make it up.

The arrangement of the electronic components (by-pass diodes) and other materials that make up this device, together with the mechanization in the form of openings made onto the short anodised aluminium frame from the side of the connection box, the design of the connection box itself, likewise the flexible encapsulating material that is used as protection for the electrical connections on the inside of the box against rusting, flames, vibrations, the entry of undesirable particles and other possible aggressions has been conceived and carried out in order to achieve appreciable advantages of durability, rapid response, electrical protection and easy repair when compared with other already existing devices that have similar aims.

### BACKGROUND OF THE INVENTION

Several systems are known for the electrical protection of photovoltaic modules in which it can been seen that protection by-pass diodes are assembled inside a reduced sized plastic connection box which also has a method of electrical connection that is used for the mechanical connection, this meaning, highly resistant. Usually these connection boxes are positioned just behind some of the cells that make up the photovoltaic module, which causes the electrical characteristics of said cells to be reduced as a result of the heat given off by the protection diodes during their activation. The above brings about a degrading of the module.

On the other hand, the by-pass diodes that are normally used have a cylindrical body, in which the only possible area for heat dissipation is formed by the two metallic feet at the ends of the body for their connection to the outside. This makes the thermal resistance of these types of diodes very high. Likewise, the normal connection of said diodes to a connection block, or similar device, on the inside of the box by means of a mechanical contact, joined with the reduced space on the inside of said connection box makes the dissipation of the heat produced by the by-pass diodes insufficient; this brings about its premature destruction and the lack of protection of the photovoltaic module to shade or poor electrical performance of some of the components.

Other electrical protection devices are known for photovoltaic modules with similar characteristics to that which is the object of this invention, as they are embedded inside of said module; however, said devices are difficult to repair in the event of a failure of the components, especially when the affected module is already assembled in an installation.

For the purpose of briefly detailing the workings of the by-pass diodes that are used for the protection of the photovoltaic module a small summary has been made in the following lines:

When the photovoltaic cells are illuminated in a uniform manner by the sun their working becomes that of a source of energy generation whilst the by-pass diodes are inversely polarised and therefore block the passage of the current through them. If a photovoltaic cell is in the shade, or its electrical response to solar radiation is reduced by a fault in same, it ceases to act as the energy source and basically becomes a power consumer element (resistance). The rest of the photovoltaic cells that are not in the shade, or whose electrical performance are correct continue to supply current through the affected one thus causing a loss of power in the form of heat that can lead onto the destruction of the shaded cell and even of the photovoltaic module. In order to prevent these problems protection diodes are installed in anti-parallel with a specified number of cells. Said protection diodes will act as by-passes in order to divert the flow of current from the rows of cells affected by the shade or from bad electrical performance.

Due to the high cost that would be brought about by electrically protecting each one of the cells that make up the photovoltaic module, the use of a single protection diode is resorted to for a group of approximately twelve to twenty-four cells that are connected in series.

### DESCRIPTION OF THE INVENTION

This present invention has been developed for the purpose of providing an electronic device that solves the above-mentioned disadvantages, in addition contributing other additional advantages that will become clear from the description that is given below.

The object of this present invention is to provide an electronic device with by-pass diodes for photovoltaic modules that is easily repairable that is recommended, made up of highly conductive, large section tin plated copper conductors, placed in a reliable and safe manner on an epoxy resin sheet with low thickness and long length glass fibre, with three by-pass diodes being assembled on these long length and section conductors for the electrical protection of the photovoltaic module. The diodes used are fitted with one cooling flange as an integral part of the encapsulation that also makes the assembly easier onto the conductor plates, facilitating the dissipation of the heat from the inside of the diode to the copper conductors of the sheet itself. The protection diodes used are the rapid response Schottky type, with very low losses in normal module working load and with high resistance to temperature at the join. Each by-pass diode protects two rows of cells, twenty-four cells connected in series, between which each diode is connected in an anti-parallel manner.

Advantageously, the front face of the device is covered with a non-conductive white opaque primer material, without ionic contamination and resistant to ultra-violet radiation in order to reduce the circuit made on the rear side.

One peculiarity of this device is the arrangement of the three protection diodes. Said device is such that it allows the said diodes to be framed, together with the connection points to which the cables are connected that conduct the electricity generated during the periods of illumination of the photovoltaic module to the outside, inside of a reduced size rectangle keeping the necessary safety distances so that the heating effect of any of the components does not have any influence on the performance of the other components of the device. This arrangement of the components of the electronic device together with the existence of openings in the upper frame of the module, clearly allows the zone to be outlined which must be accessed in the event of having to carry out any actions on the electronic device. On the other hand, an easily repairable dielectric encapsulation is used as encapsulation and protection for the active parts on the inside of the connection box that has good chemical stability properties, which in addition to its flexible nature prevents damage to the electrical and electronic components from impacts, vibration or fatigue and which has the nature of good thermal conductivity thus helping with the dissipation of heat generated on the inside of the cable connection box. This encapsulation is also resistant to ultra-violet radiation and flames.

This electronic device is intended to be positioned by preference on the upper end of the photovoltaic module, sufficiently far away from the cells so that the electrical performance of these is not affected by the possible heating up of the diodes that make it up. In addition, the arrangement of the conductor plates of the device of the invention make possible the closure of the electrical circuit of the photovoltaic module once they are connected onto them, by means of soldering or another connection system, the corresponding conductor ends of the differing rows of photovoltaic cells, likewise the flat conductor strips that are joined to some electrical terminals inside the connection box, from where the electrical cables go to the outside for the electrical energy that is produced by the module. So as to ensure a good mechanical and electrical join, and to reduce the losses of potential to a minimum from series resistance, electrical connection systems are used for the stated cables by means of mechanical crimping and soldering techniques.

Advantageously, the by-pass protection diodes are fitted with an SMD type of encapsulation with cooling flanges, that in addition make the assembly easier onto the conductor plates making the heat dissipation easier from the inside of the diode to the electronic device copper conductors. Each diode protects a set of two row group of cells connected to each other in series and between which each diode is connected in anti-parallel.

### A BRIEF DESCRIPTION OF THE DRAWINGS

In order to complement the description that is being made in this present description and for the purpose of giving a greater understanding of the nature of the invention, a set of descriptive drawings is attached to this present descriptive description, as an integral part of same, with different drawings that are by way of illustration and without being by way of limitation and which represents the most significant details of the invention
Figure 1 shows a plan view of the front of the electronic device in accordance with the present invention;
Figure 2 shows a plan view of the rear face of the electronic device;

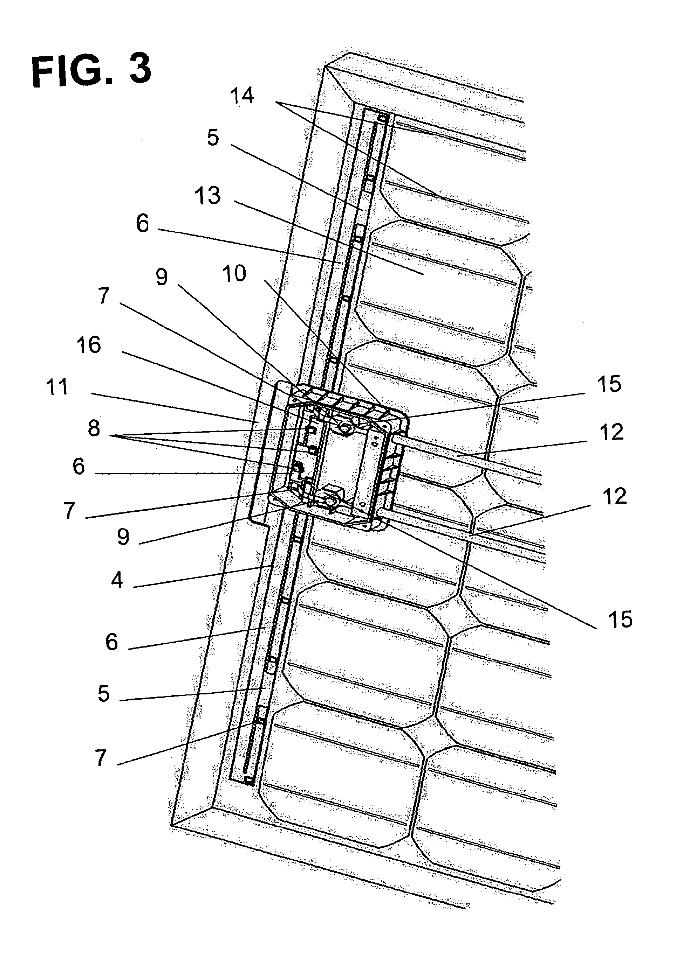

Figure 3 shows an expanded view in perspective of the rear face of a part of the assembly of a photovoltaic module and, the inside of the connection box so as to be able to clearly see the arrangement of the electronic device with by-pass diodes in a photovoltaic module; and

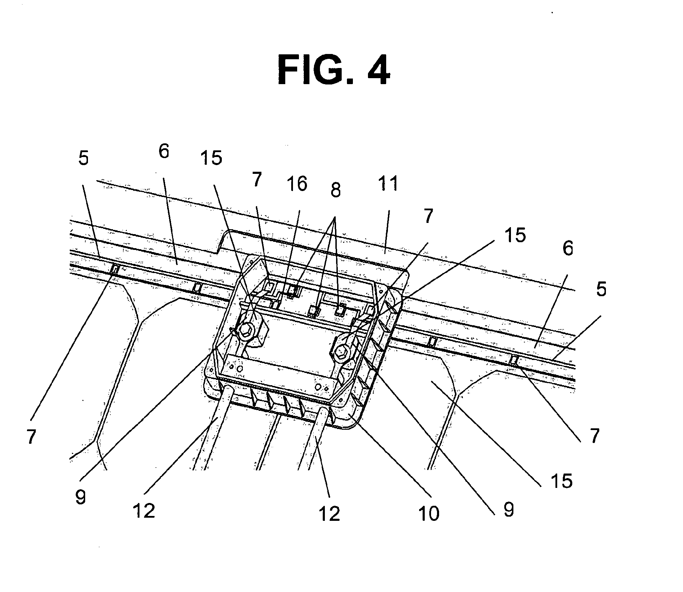

Figure 4 shows an expanded perspective view of a part of the assembly of a photovoltaic module from a point of view that is different to that shown in the previous figure.

### A DESCRIPTION OF A PREFERRED EMBODIMENT

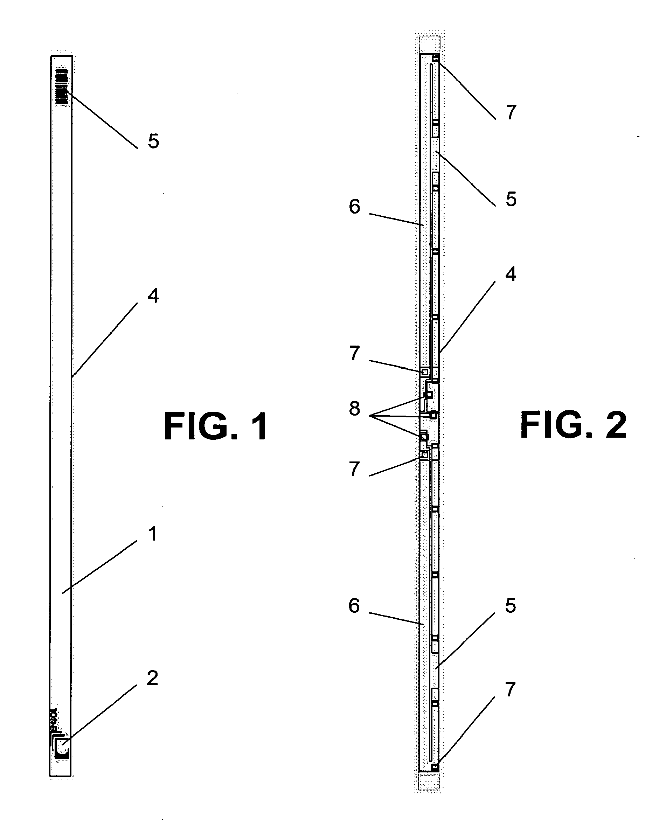

In regard to the stated figures, it can be seen that the elongated electronic device (4) of the invention, is made up of a substrate of epoxy resin with glass fibre (5) with good electrical and mechanical properties and reduced thickness onto the rear face of which some electronic grade copper metallisations (6) are deposited with the geometry as shown in Figure 2, covered on the entirety with a layer of tin having a sufficient thickness and purity to make the soldering adequate for the differing conductors of the photovoltaic module onto the electronic device and, which protects it from oxidation. An essential characteristic for the good performance of the electronic device is good adhesion of the metallised material on the substrate (5).

As can be deduced from the figures, the electronic device (4) has a general shape of an elongated strip with reduced thickness compared to the length.

As can be seen from figure 2, some rectangular shaped soldering masks (7) are applied on the rear of the device to the surface of the tin plated copper sheets (6), for the purpose of outlining the position and soldering areas of: The conductor strips (14) that are used for the electrical connection of each one of the rows of photovoltaic cells (13) towards the device (4) that is detailed, the three by-pass diodes (8) assembled onto the device (4) and the conductor strips (9) with a size that is appreciably greater than those mentioned above, that exit from the electronic device (4) towards the connection terminals (15)assembled onto the box (10) installed on the rear sheet of the photovoltaic module. The material used for these soldering masks (7) is non-conducting, it does not contain ionic contaminations and amongst its other characteristics, it is resistant to ultra-violet radiation, likewise the heat given off during the soldering process.

In accordance with figure 2, three rapid response Schottky type by-pass diodes (8) with the already described features have been integrated approximately into the centre of the electronic device (4). Each diode (8) protects two rows of photovoltaic cells (13) that are connected to each other in series and is connected anti-parallel between them.

Another characteristic of the device is that the front face of figure 1, will be silk screened in a white opaque colour (1) with a non-conducting material, without ionic contamination and with resistance to the ultraviolet radiation, for the purpose of concealing the electrical circuit made in the rear face, figure 2, of the stated device (4). As this front face is the part that is visible to the outside, the name or logo of the company (2) and the series number or individual identification (3) of each photovoltaic cell can be marked.

The three by-pass diodes (8), together with the connection points of the conductor strips (9) that are connected to the cables (12) that take the electricity generated by the photovoltaic module to the outside, are encased in a small sized rectangle. From this arrangement, with the machining made in the form of an opening into the short aluminium frame (11) positioned on the end of the module that contains the connection box (10), along with the use of a flexible and semi-transparent electronic grade encapsulation (16), appreciable advantages of easy repair, durability, rapid response and electrical protection can be obtained when compared to the other already existing devices with similar aims.

The electronic device (4) is designed so as to be inserted on the inside of the photovoltaic module between the encapsulating layers, superstrate, photovoltaic cells matrix (13) and the rear insulating sheet. It is positioned on the upper end of the photovoltaic module, sufficiently far away from the photovoltaic cells (13) so that the electrical performance of these is not affected by the possible heating of the diodes (8) during the periods of activity.

It is not considered necessary to make this description more extensive as any expert in the matter can understand the scope of the invention and the advantages that are provided by same.

The materials, shape, size, quantity and arrangement of the constitutive elements can be varied provided that they do not alter the essence of the invention.

The terms in which it has been described in this invention must always be taken in their broadest sense and without being by way of limitation.

## Claims

1. Elongated electronic device (4), particularly for embedding inside of a photovoltaic module, between the layers of encapsulating material, photovoltaic cells matrix (13), glass superstrate and rear insulating sheet, **characterised in that** it is made from tin plated copper conductors (6) that have high conductivity and section, placed in a reliable and safe manner on an elongated plate of epoxy resin with glass fibre (5), onto which three Schottky type by-pass diodes (8) are assembled, which are connected to the cables conducting the electricity generated by the photovoltaic module, the front face of the module being covered with an opaque white primer (1) of a non-conductive material, without ionic contamination and resistant to ultra-violet radiation.

2. Elongated electronic device (4), embedded inside of a photovoltaic module, according to claim 1, **characterised in that** the protection by-pass diodes (8) are fitted into an SMD type encapsulation with cooling flange, each diode (8) protecting a group of two rows of cells (13) connected to each other in series and connected anti-parallel between them.

3. Elongated electronic device (4), embedded inside of a photovoltaic module, according to claim 1, **characterised in that** the arrangement of the three by-pass diodes (8) is such that they are encased, together with the connection points to which the cables (12) are connected, conducting the electricity to the outside of the module, inside of a reduced sized rectangle whilst keeping a safe distance.

4. Elongated electronic device (4), embedded inside of a photovoltaic module, according to claim 1, **characterised in that** there is an opening made in the short anodised aluminium frame (11) located at the end of the module that contains the connection box (10).

5. Elongated electronic device (4), embedded inside of a photovoltaic module, according to claim 1, **characterised in that** it has a protective encapsulation (16) made from a flexible dielectric material.

6. Elongated electronic device (4), embedded inside of a photovoltaic module, according to claim 5, **characterised in that** said encapsulation is a semi-transparent material.
